Europäisches Patentamt

European Patent Office

Office européen des brevets

(19)

(11) Publication number: **0 157 780**
**B1**

## EUROPEAN PATENT SPECIFICATION

(12)

(45) Date of publication of patent specification: **18.05.88**

(51) Int. Cl.⁴: **H 01 L 21/76**

(21) Application number: **84900564.0**

(22) Date of filing: **12.12.83**

(86) International application number:
**PCT/US83/01959**

(87) International publication number:
**WO 85/01613 11.04.85 Gazette 85/09**

(54) **HIGH DENSITY MOSFET WITH FIELD OXIDE ALIGNED CHANNEL STOPS AND METHOD OF FABRICATING THE SAME.**

(30) Priority: **30.09.83 US 537920**

(43) Date of publication of application:
**16.10.85 Bulletin 85/42**

(45) Publication of the grant of the patent:
**18.05.88 Bulletin 88/20**

(84) Designated Contracting States:
**CH DE FR GB LI NL**

(56) References cited:
**EP-A-0 065 464**
**EP-A-0 111 097**
**EP-A-0 121 351**
**US-A-4 418 094**

**IEEE Transactions on Electron Devices, vol. ED-29, no. 4, April 1982 (New York, US) K.L. Wang et al.: "Direct moat isolation for ULSI", pages 541-547**

**Japanese Journal of Applied Physics, vol. 18, 1979, Supplement 18-1 (Tokyo, JP) T. Shibata et al.: "A new field isolation technology for high density MOS LSI", pages 263-267**

**Patents Abstracts of Japan, vol. 7, no. 233 (E-204) 15 October 1983 page 1378, JP, A, 58121643 (Toshiba) 20 July 1983**

(73) Proprietor: **Hughes Aircraft Company**
**7200 Hughes Terrace P.O. Box 45066**
**Los Angeles California 90045-0066 (US)**

(72) Inventor: **CHEN, John, Y.**
**12926 Lucille Avenue**
**Los Angeles, CA 90066 (US)**
Inventor: **HENDERSON, Richard, C.**
**1121 Stoneshead Court**
**Westlake Village, CA 91361 (US)**

(74) Representative: **Kuhnen, Wacker & Partner**
**Schneggstrasse 3-5 Postfach 1729**
**D-8050 Freising (DE)**

(56) References cited:
**IBM Technical Disclosure Bulletin, vol. 25, no. 7A, December 1982 (New York, US) V.J. Silvestri et al. "Practical selective epitaxial process for oxide isolation", pages 3329-3330**

## Description

The present invention relates to a method of fabricating a MOSFET device comprising a substrate and an active device region at a surface of said substrate, said active device region comprising a first dopant; a channel stop at the surface of said substrate adjacent said active device region, said channel stop comprising a second dopant; and a field oxide layer overlying and adjacent said channel stop, an edge of said oxide layer being aligned with said channel stop at the point where said channel stop is adjacent said active device region and wherein the thickness of said field oxide layer and the concentration of said second dopant in said channel stop preclude any significant amount of leakage current from flowing under said field oxide during the operation.

The fabrication of such a MOSFET device is known from the EP—A—65 464, JP—A—58—121 643, or "Proceedings of the 10th Conference of Solid State Devices", 1978, pages 263 to 267. In fabricating the known devices the whole surfaces of the substrate is covered by the field oxide during the implanting of the channel stoppers in the substrate. This means that the area of the active device region is covered by the field oxide, too. During the forming of the channel stop between the mask for the active device area and the active device area an additional intermediate layer of field oxide is disposed, and therefore the ions of the dopant can penetrate at the side portions of this intermediate layer into the active device region.

Providing for device isolation has been one of the more critical problems in fabricating integrated circuits. As the packing density increases for VLSI applications, device isolation can place a fundamental limit on circuit design complexity and density. A number of prior art processes for isolating devices in integrated circuits have been available but none have been completely satisfactory due to the severe design constraints which must be adhered to. In particular, a preferred isolation technology should satisfy the following requirements:

(1) Leakage current must be negligible between active devices. For MOS technology, this means the silicon surface under the field oxide cannot be even weakly inverted during circuit operation. Because of shifts in field oxide threshold voltage ($V_{TF}$) due to variations in spacing between active devices, temperature, and radiation exposure, it is necessary to provide adequate margins for $V_{TF}$ shift by making $V_{TF}$ as high as possible, typically, 15—20 volts, to ensure complete VLSI active device isolation.

(2) Spacing between active devices should be minimal. This requirement is particularly important for obtaining VLSI packing densities.

(3) Isolation should not consume a significant portion of the active device area or result in significant narrow-channel effect.

(4) The isolation process should not significantly constrain the process parameters required for fabricating the active device. In this way, the performance and isolation of the active device can be independently optimized.

(5) The isolation process should be relatively simple to control.

(6) For some applications, the above requirements must be maintained in high temperature or radiation environments.

Typical of the conventional MOS processes used for the isolation of active devices in MOS integrated circuits is the local oxidation of silicon (LOCOS) process described in the article by Looi et al., "Formation of Silicon Nitride at an Si—SiO$_2$ Interface During Heat Treatment of Oxidized Silicon in NH$_3$ Gas", Journal of the Electrochemical Society, Vol. 123, p. 1117, 1976. In accordance with this method, a nitride mask is provided over the eventual active device areas as a shield during an implantation of boron ions, the isolation areas thereafter being selectively oxidized. However, applying LOCOS for VLSI isolation is limited by field oxide encroachment (bird's beak phenomenon) and by lateral diffusion of channel stop dopants into the eventual active device areas. Both effects overtake the active area near the channel edges. This channel narrowing effect will increase the FET threshold voltage and reduce its current driving capability. To maintain the desired channel width, the corresponding mask dimension must be drawn oversize, resulting in wasted layout area and poor packing density for IC fabrication.

Although subsequently developed LOCOS isolation techniques have reduced the narrow channel effects, other problems, such as process complexity, still make the search for alternative processes for integrated circuit fabrication desirable.

An improvement to the LOCOS process described above is direct window isolation which provides advantages for the isolation in high density ICs. In an article by Wang, et al., "Direct Moat Isolation for VLSI", IEEE Transactions on Electron Devices, ED—29, p. 541, 1982, the placement of LOCOS by direct window isolation is disclosed. This technique employs only a single boron implant to form both channel stops and channel regions. This technique, however, is not completely satisfactory for an optimized MOS process since high junction capacitance and poor body effect for the active devices result, as well as a low field inversion voltage for field oxide regions. Body effect is the sensitivity of threshold voltage to substrate bias. This effect reduces driving current and limits logic swings in MOS integrated circuits.

The present invention as claimed provides a process for fabricating a MOSFET device having field oxide self-aligned channel stops for device isolation and with optimized doping of the various regions of the active devices.

According to the EP—A—121351, published 10-10-84, the channel stoppers are implanted during a stage at which substantial structural features of the MOSFET are already deposited on the active device region.

The invention differs also from the EP—A—111097, published 20-6-84 in that the step

for implanting a dopant in the active device area is performed after the implanting of the channel stops.

Performing the invention, the process steps may involve growing or depositing the field oxide over a silicon substrate, patterning active areas by a photoresist, etching oxide away from the active areas, implanting a shallow layer of dopant in the active areas, evaporating metal over the substrate and lifting off the remaining photoresist leaving metal over the active areas making a deep dopant implant to form channel stops under the field oxide only, and then removing the remaining metal. In situations wherein both enhancement and depletion mode devices are to be formed on respective active areas of the same substrate, the depletion devices are patterned by photoresist, implanting a shallow dopant layer to form the depletion devices and thereafter removing the photoresists. The devices are then completed by utilizing conventional FET processing technology.

Thus each device fabricated in accordance with the present invention has channel stops that are self-aligned to the field oxide which permits the high packing density necessary for VLSI integrated circuits. The active devices, due to the separate dopant implants for channel stops and active regions, have low junction capacitance and minimum body effect, thus enabling high speed, high performance integrated circuits to be fabricated.

The isolation process according to the teaching of the present invention also provides higher packing densities than conventional processes, particularly NMOS processes, a high field oxide inversion voltage which ensures rigid device isolation even in radiation environments, and virtually no field oxide encroachment or oxidation-induced lateral channel stop dopant diffusion so that the active channel width is not narrowed.

The process described above, in addition to providing the noted advantages, is accomplished in a relatively simple and cost effective manner.

Brief Description of the Drawings

For a better understanding of the invention as well as other advantages and further features thereof, reference is made to the following description which is to be read in conjunction with the accompanying drawings wherein:

FIG. 1 is a cross-sectional view of a MOSFET device fabricated in accordance with the present invention; and

FIGS. 2—7 are cross-sectional views which illustrate the method of fabricating the isolation structure portion of the device of FIG. 1.

It should be noted that the same reference numerals identify like components in each of the figures.

Detailed Description of the Invention

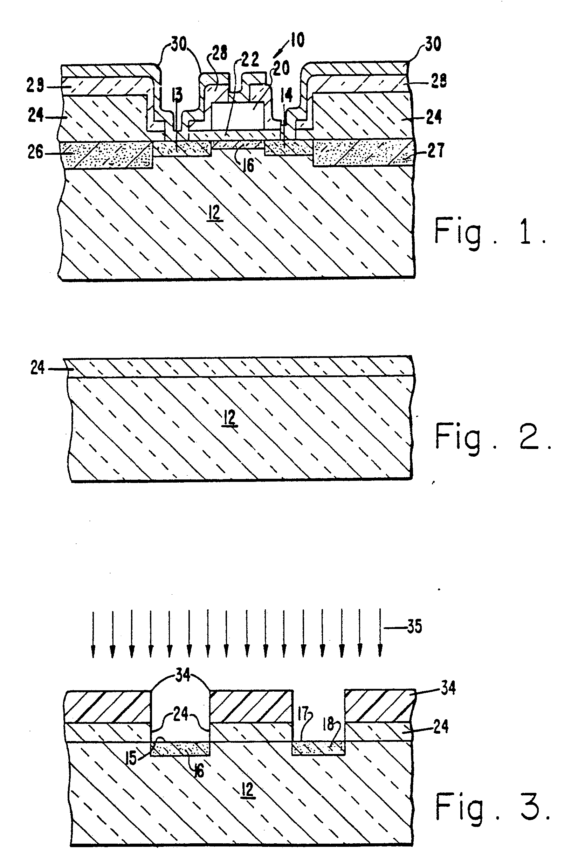

A MOSFET type device 10 incorporating the novel channel stop structure of the present invention is shown in FIG. 1. As will be explained hereinafter with reference to FIGS. 2—7, the isolation process of the present invention can be utilized to form both enhancement and depletion mode MOSFETS in the same integrated circuit. For the purpose of clarity, only the formation of an enhancement MOSFET is shown in FIG. 1. It also should be noted that although the isolation process is described in the context of NMOS devices, PMOS devices can similarly be fabricated with the process. Moreover, the isolation process of the present invention can be utilized in the fabrication of both NMOS and PMOS devices on the same substrate as needed for CMOS. Since NMOS devices, due to their higher speed of operation and smaller size, are more widely used in the industry than PMOS and CMOS devices, the following description will be directed to the fabrication of NMOS devices. Also, the device can be fabricated utilizing essentially any semiconductor and compatible oxide. Preferably, silicon and silicon dioxide are employed. Device 10 comprises a semiconductor substrate 12, here silicon, having an $n^+$ source region 13 and an $n^+$ drain region 14. An active channel 16 is formed at the upper surface of substrate 12 and a gate electrode 20, here polysilicon or silicide, overlies a thin gate oxide layer 22 as illustrated. A thick field oxide layer 24 is formed on the surface of substrate 12 and, as will be explained hereinafter, is utilized in conjunction with channel stop layers 26 and 27 to provide device isolation. A layer 28 of insulating oxide, here silicon dioxide, is formed over the underlying field oxide layer and the gate electrode, preferably by chemical vapor deposition (CVD) techniques. The device 10 is completed by etching holes through the field oxide 24 and insulating oxide 28 layers in areas corresponding to the drain 14, source 13 and gate 20. Contacts and interconnects 30 are then formed in accordance with the desired circuit configuration.

Referring now to FIG. 2, in order to fabricate active devices 10 having an isolation structure consistent with the present invention one starts with a substrate or body 12 of P-type semiconductor material, preferably silicon doped with an impurity such as boron to provide p-type conductivity. A field dioxide layer 24, preferably silicon dioxide is thermally grown or CVD deposited on the surface of substrate 12 by conventional techniques, layer 24 having a thickness in the range from about 400 nm (4000Å) to about 600 nm (6000Å). Referring to FIG. 3, active areas 15 and 17 are patterned with conventional positive photoresist 34, such as Shipley AZ, and the silicon dioxide overlying the active areas 15 and 17 is etched away in a conventional manner. The thickness of the photoresist layer 34 is in the range from about 1 μm to about 2 μm.

A p-type dopant, typically boron, is then implanted as represented by arrows 35, into the active areas 15, 17 to form shallow active channel regions 16, 18 respectively. The implant is preferably performed at an energy in the range from about 20 KeV to about 30 KeV and to a dosage in the range from about $7 \times 10^{11}$ ions/cm$^2$ to about $1.5 \times 10^{12}$ ions/cm$^2$. Alternately a double implant can be utilized for sub-micrometer active channel lengths, with boron initially being implanted at an energy in the range from about 20 KeV to about 30 KeV and a dosage in the range from about $7 \times 10^{11}$ ions/cm$^2$ to about $1 \times 10^{12}$ ions/cm$^2$, and a second stop of implanting boron at an energy of about 70 KeV and a dosage of about $4 \times 10^{11}$ ions/cm$^2$. The thickness of both the relatively shallow active channel regions 16 and 18 is in the range from about 0.1 µm to about 0.3 µm. Other p-type dopants may be utilized to form the active channel including, for example, gallium, and implanted at energies and dosages which depend on the substrate material and quality and the type of MOSFET device to be fabricated. The implant conditions are chosen such that the performance characteristics of the active devices 10 being fabricated (e.g., low threshold, low punchthrough current, minimum body effect and low junction capacitance) are optimized.

Although the single boron implant can provide desirable device performance for all active channel lengths, it is most effective for channel lengths greater than 1 µm. Use of the two step boron implant further suppresses the punchthrough effect which is particularly desirable for channel length less than 1 µm, and is thus preferred in such cases.

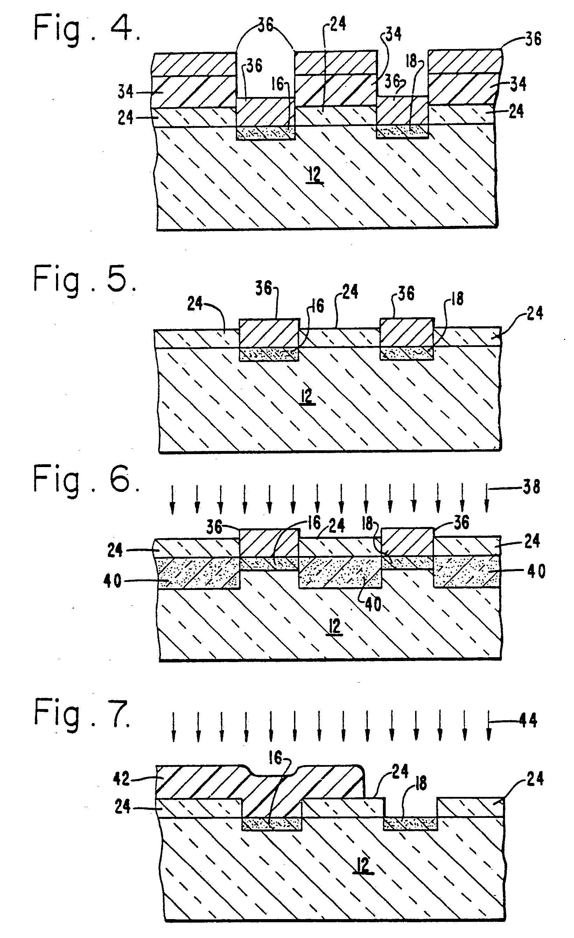

After the shallow boron implant, a layer of metal 36 is evaporated onto the surface of substrate 12 as shown in FIG. 4. Metal layer 36, typically aluminum (Al) or gold (Au), has a thickness in the range from about 0.4 µm to 0.7 µm for Au and from about 0.7 µm to about 1.3 µ for Al. The portion of the metal layer overlying the photoresist layers is removed by a conventional lift-off process by placing the substrate 12 in a chemical organic solution which dissolves the photoresist 34, leaving the metal overlying the active areas 16 and 18 as shown in FIG. 5, (the resist/oxide composite layer acts as a two-level resist which facilitates the lift-off). The next step is to form a deep p$^+$ dopant implant under the field oxide layer 24. The implant energy is selected to be high enough to place the peak implantation concentration just beneath the field oxide (FIG. 6), but insufficient to penetrate the metal layer 36 which masks the active areas. The implant dose (represented by arrows 38) is chosen to provide a relatively high doping concentration for channel stop regions 40 under the field oxide 24. Preferably, boron is implanted through the field oxide 24 at an energy in the range from about 120 KeV to about 200 KeV and to a dosage in the range from about $5 \times 10^{12}$ ions/cm$^2$ to about $1 \times 10^{13}$ ions/cm$^2$. Finally, the metal layer 36 is then stripped by a conventional metal etching process.

At this point in the process, the basic isolation structure fabricated in accordance with the teachings of the present invention is complete. In order to put the invention to proper perspective, the following will briefly describe the process steps utilized to fabricate the device shown in FIG. 1. Naturally, other process techniques and sequences may be used to complete the MOS structure consistent with the present invention.

For illustrative purposes, it is assumed that at least two MOSFETS are being fabricated as part of an integrated circuit and that one MOSFET is an enhancement mode active device and the other a depletion mode active device. The additional processing steps needed to form a depletion mode device will be described with reference to FIG. 7. The depletion device is patterned by a photoresist (conventional masking step is utilized), so as to form a photoresist mask 42 over the channel region, 16 in this case, of the eventual enhancement mode active device. A shallow implant (represented by arrows 44), preferably of arsenic or phosphorus, is then performed to counter-dope the boron implanted region 18 with additional dopant as needed to ultimately form a depletion mode active device. The photoresist layer 42 is then removed and the substrate 12 is ready for conventional processing to form the completed depletion mode and enhancement mode MOSFETs.

Again referring to FIG. 1, a thin oxide gate layer 22 (thickness in the range from about 20 nm (200Å) to about 100 nm (1000Å) is deposited or thermally grown over the otherwise exposed surface of the substrate 12, a layer of polysilicon 20 then being applied over the thin film oxide layer by chemical vapor deposition (CVD) techniques; the polysilicon film 20 is then doped with phosphorus to make the film conductive; a conventional photoresist masking process is next utilized to define the polysilicon gate 20; the remaining portion of the polysilicon layer and the photoresist layer are stripped away, leaving a polysilicon gate on top of the thin oxide film. Arsenic is then implanted at an energy in the range from about 50 KeV to about 150 KeV and at a dosage in the range from about $1 \times 10^{15}$ ions/cm$^2$ to about $1 \times 10^{16}$ ions/cm$^2$ to form the n-type MOSFET source and drain regions 13 and 14, respectively; a silicon dioxide layer 28 then being formed over the polysilicon gate by chemical vapor deposition techniques to form an insulation layer; another masking and etching procedure is utilized to make appropriate contact holes at the gate and n$^+$ dopant regions; a layer of metal 30, such as aluminum overlying a tungsten-titanium (WTi) film, is evaporated over the substrate surface; and then a masking/etching step is utilized to make the appropriate connections depending upon the circuit configuration desired.

Thus, through the use of the lift-off technique in the above manner consistent with the present invention, separate and, thereby, independently optimizable implants may be utilized to form the channel stop 40 and channel regions 16, 18. Moreover, the channel stop 40 is inherently self-aligned to the edges of the field oxide 24 and the channel regions 16 and 18, thus allowing for accurate placement of the channel stop as required for increased integrated circuit packing densities. It should be noted that this independent doping concentration control eliminates the necessity of counter-doping or providing dopant compensation as is required in the fabrication of prior art devices.

Note that using the field oxide 24 as a mask enables the edges of the underlying channel stop 40 to be aligned with the edges of the field oxide layer 24. This allows the circuit designer to take full advantage of the chip area, thus increasing VLSI packing densities. Also, note that to minimize body effect while suppressing punchthrough current, the active channel layer implant depth is limited to within the source (drain) junction depth.

Thus, typical channel lengths for devices fabricated in accordance in the present invention may range from about 0.5 μm to about 5 μm and typical implanted channel thickness range from about 0.1 μm to about 0.3 μm. It has been determined that the threshold voltages (defined at 1 μA) for the depletion mode and enhancement mode MOSFETs fabricated in accordance with the teachings of the present invention remain essentially constant (0.25 V for enhancement, −0.75 V for depletion) for a selected substrate bias voltage. Similarly, the threshold voltages vary within a narrow range for relatively larger variations in substrate voltage.

The device isolation characteristics of MOS devices depend on the potential under the field oxide. For a 400 nm (4000Å) field oxide thickness and 20 nm (200Å) gate oxide thickness and an isolation spacing of about 1 μm (distance between active areas), at 5 V gate operation, no field inversion (current channel formation) occurs under the field oxide in devices fabricated in accordance with the present invention. At a gate voltage of 15 volts, no electrons appear in the main area of the isolation region, thus confirming that excellent device isolation characteristics are provided. This is the case even at submicrometer isolation dimensions.

The performance of the active devices fabricated in accordance with the present invention are also enhanced. In particular, it has been determined that there is no severe punchthrough current (when gate length gets smaller and n+ regions become closer together, current [punchthrough] may flow even when gate voltage is not applied) when the devices are operated at typical MOSFET biasing voltages i.e., 5 V. Further, the tailoring of the active channel dopant concentrations to the appropriate values reduces the body effect (change of threshold voltage with change in substrate bias). The junction capacitance between n+ implant regions and the substrate is also reduced by accurately controlling the original shallow boron implant.

The use of direct window isolation by ion implantation eliminates the occurrence of field oxide encroachment while the formation of the channel stop after the field oxide growth minimizes oxidation-induced lateral boron diffusion, thus eliminating the physical channel narrowing effect.

A heavily doped substrate normally will increase junction capacitance, decreasing the speed of device operation, and will also increase the body effect, thus changing device performance for a change in substrate bias. The shallow boron active region implant utilized in the present invention avoids heavily doping the substrate which would be normally required when a single implant is used to form both the active and isolation regions.

In prior art devices, a thick field oxide by itself would normally prevent normal device voltages from causing current from flowing underneath the oxide. However, unless the oxide thickness is very large (>1 μm), thereby causing photolithographic step-coverage problems necessitating wide isolation spacing, leakage currents would flow resulting in device and circuit failure. The combination of a relatively thinner field oxide layer of a predetermined thickness and channel stop, as provided in accordance with the present invention, provides essentially complete device isolation and thus prevents device cross-talk. In particular, devices fabricated in accordance with the present invention have field oxide thresholds in the range from 15 V to about 25 V, thus ensuring device isolation despite the aforementioned body effect threshold shifts. For example, at 4 μm isolation spacing, 400 nm (4000Å) field oxide thickness, and 14 V, it has been determined that there is less than 1 pA subthreshold leakage in the field region. Even at 1 μm isolation, less than 1 pA is achieved up to 12 V. Thus requirements for rigorous isolation with high density NMOS ICs are met by the process. As noted, at 5 V operation, this isolation provides sufficient margin for field threshold shifts caused by high temperature ambients or ionizing radiation.

Example

Device structures of the type shown in FIG. 7 have been fabricated with the following parameters: a silicon substrate 12 of thickness of 250 μm and a resistivity of 10—15 ohm-cm; a silicon dioxide layer 24 with a thickness of 4000Å; boron channel stoppers 40 implanted at an energy of 120 KeV and a dosage of $1 \times 10^{13}$ ions/cm² with a corresponding isolation spacing of 4 μm; and a channel length of 1.5 μm implanted with boron at an energy of 20 KeV and a dosage of $9 \times 10^{11}$ ion/cm² to form an enhancement mode device. Depletion mode devices were formed by additionally implanting the channel with arsenic at an energy of 60 KeV and a dosage of $1.2 \times 10^{12}$ ion/cm².

The resulting active devices have excellent device characteristics. It has been determined that the threshold voltages were 0.25 V and −0.75 V for the enhancement and depletion mode FETs respectively, that there was no punchthrough current for a gate length of 1.25 μm at 5 V drain bias; that the body effect coefficients are very low (0.1 to 0.2) for both enhancement and depletion FETs, the latter having a channel length = 2 µm, and that the device threshold remains constant as channel width decreases, i.e., there is no narrow-channel effect.

The present invention thus provides a novel process for fabricating high speed, high performance integrated circuits having a high packing density for VLSI circuits. Each active device isolation region on the chip occupies a minimum amount of substrate surface area by providing channel stops which are self-aligned to the field oxide. The present invention allows the channel stops to be doped independently from the doping of the channel regions of the active devices.

The active devices formed in the manner described hereinabove have the low junction capacitance and minimum body effect features necessary for high speed, high performance integrated circuits since the implant used for the channel stop does not introduce unwanted dopants into the active channel region, thereby allowing independent optimization of the doping concentrations for the active devices.

Thus, high density VLSI with excellent device isolation can be achieved by the process. The process employs a direct window self-aligned channel stop isolation in order to eliminate bird's beak and lateral dopant diffusion into the active area, thus avoiding narrowing of the active channel. The fabrication of the present invention is relatively simple to implement and provides a cost effective technique for fabricating high speed, high performance, integrated circuits.

It should be understood from the foregoing that many variations of the present invention are contemplated and that further modifications may be made in light of the above teachings. It is therefore to be understood that, within the scope of the appended claims, the invention may be practiced other than as specifically described.

**Claims**

1. A method of fabricating a MOSFET device comprising:

a substrate (12);

an active device region (16) at a surface of said substrate (12) said active device region (16) comprising a first dopant;

a channel stop (26, 27) at the surface of said substrate adjacent said active device region, said channel stop (26, 27) comprising a second dopant; and

a field oxide layer (24) overlying and adjacent said channel stop (26, 27), an edge of said oxide layer (24) being aligned with said channel stop at the point where said channel stop (26, 27) is adjacent said active device region (16), and

wherein the thickness of said field oxide layer (24) and the concentration of said second dopant in said channel stop (26, 27) preclude any significant amount of leakage current from flowing under said field oxide (24) during the operation of said device, characterized by the steps of:

a) providing a field oxide layer (24) on a portion of the surface of said substrate (12) adjacent the active device surface area (15) of said active device region (16), an edge of said field oxide layer (24) being aligned with a boundary point of said active device surface area (15);

b) implanting a dopant (35) into said active device surface area (15) to form said active device region (16);

c) providing a mask (36) overlying said active device region (16);

d) implanting ions into said substrate at an energy level insufficient for said ions to penetrate said mask (36), but with sufficient energy to pass through said field oxide layer (24) to form a channel stop (40) self-aligned to said field oxide layer (24) and correspondingly aligned with said active device area (15); and

e) removing said mask (36) and completing the MOS structure.

2. A method for producing a MOSFET of claim 1 wherein said ions are implanted at an energy level in the range from about 120 KeV to about 200 KeV and at a dosage in the range from about $5 \times 10^{12}$ ions/cm$^2$ to about $1 \times 10^{13}$ ions/cm$^2$.

3. A method for producing a MOSFET of claim 1 wherein the thickness of said field oxide layer is in the range from about $4 \times 10^{-7}$m (4000 Å) to about $6 \times 10^{-7}$m (6000 Å).

4. A method for producing a MOSFET of claim 1 wherein said step of forming said field oxide layer (24) comprises the steps of:

a) forming an oxide layer (24) over the surface of said substrate (12);

b) forming a temporary mask (34) over said oxide layer (24) defining the boundary of said active device area (15); and

c) removing that portion of said oxide layer (24) defined by said temporary mask (34) so as to expose said active device area (15).

5. A method for producing a MOSFET of claim 1 wherein the step of providing said mask (36) comprises the steps of:

a) providing a metal layer (36) overlying the surface of said substrate; and

b) removing said temporary mask (34) so as to lift-off the overlying portion of said metal layer (36).

6. A method for producing a MOSFET of claim 1 wherein said active device region (16) is provided under said active device area (15) subsequent to the step of exposing said active device area (15) and prior to providing said mask (36) and wherein a dopant is implanted into said substrate (12) and the thickness of said implanted active device region (16) is in the range from about 0.1 µm to about 0.3 µm.

7. The method of claim 6 where said dopant is implanted at an energy level in the range from about 20 KeV to about 30 KeV at a dosage in the range from about $7 \times 10^{11}$ ions/cm$^2$ about $1.5 \times 10^{12}$ ions/cm$^2$.

8. A method for producing a MOSFET of claim 1 wherein said substrate (12) comprises silicon and said field oxide layer (24) comprises silicon dioxide.

**Patentansprüche**

1. Verfahren zum Herstellen eines MOSFET-Elementes, welches aufweist:

ein Substrat (12);

einen aktiven Elementbereich (16) an einer Oberfläche des Substrates (12), wobei dieser aktive Elementbereich (16) eine erste Dotierung aufweist;

eine Kanalbegrenzung (26, 27) an der Oberfläche des Substrates benachbart zu dem aktiven Elementbereich, wobei die Kanalbegrenzung (26, 27) eine zweite Dotierung aufweist; und

eine Feldoxidschicht (24), welche die Kanalbegrenzung (26, 27) überdeckt und benachbart zu ihr ist, wobei ein Rand der Oxidschicht (24) mit der Kanalbegrenzung ausgerichtet ist, an einem Punkt, wo die Kanalbegrenzung (26, 27) benachbart mit dem aktiven Elementbereich (16) ist, und worin die Dicke der Feldoxidschicht (24) und die Konzentration der zweiten Dotierung in der Kanalbegrenzung (26, 27) eine signifikante Menge des Leckstroms ausschließt, der unter dem Feldoxid (24) während des Betriebs des Elementes fließt, gekennzeichnet durch die folgenden Schritte:

a) Bereitstellen einer Feldoxidschicht (24) auf einen Bereich der Oberfläche des Substrates (12), nahe dem aktiven Elementoberflächenbereich (15) des aktiven Elementbereichs (16), wobei ein Rand der Feldoxidschicht (24) mit einem Begrenzungspunkt des aktiven Elementoberflächenbereichs (15) ausgerichtet ist;

b) Implantieren einer Dotierung (35) in den aktiven Elementoberflächenbereich (15), um den aktiven Elementoberflächenbereich (16) zu bilden;

c) Bereitstellen einer Maske (36), welche den aktiven Elementbereich (16) überdeckt;

d) Implantieren von Ionen in das Substrat bei einem Energiepegel, der für die Ionen ungenügend ist, um die Maske (36) zu durchdringen, aber mit geeigneter Energie, um die Feldoxidschicht (24) zu durchdringen, um eine Kanalbegrenzung (40) zu bilden, welche selbstjustierend zu der Feldoxidschicht (24) und übereinstimmend-ausgerichtet mit der aktiven Elementfläche (15) ist; und

e) Entfernen der Maske (36) und Vervollständigen der MOS-Struktur.

2. Verfahren zum Herstellen eines MOSFET nach Anspruch 1, worin die Ionen bei einem Energiepegel implantiert werden, der im Bereich von näherungsweise 120 keV bis näherungsweise 200 keV liegt, und einer Dosierung im Bereich von näherungsweise $5 \times 10^{12}$ Ionen/cm$^2$ bis näherungsweise $1 \times 10^{13}$ Ionen/cm$^2$.

3. Verfahren zum Herstellen eines MOSFET nach Anspruch 1, worin die Dicke der Feldoxidschicht im Bereich von näherungsweise $4 \times 10^{-7}$m (4000 Å) bis näherungsweise $6 \times 10^{-7}$m (6000 Å) ist.

4. Verfahren zum Herstellen eines MOSFET nach Anspruch 1, worin der Schritt des Formens der Feldoxidschicht (24) die folgenden Schritte aufweist:

a) Bilden einer Oxidschicht (24) über die Oberfläche des Substrates (12);

b) Bilden einer temporären Maske (34) über die Oxidschicht (24), welche die Begrenzung der aktiven Elementfläche (15) definiert; und

c) Entfernen des Bereichs der Oxidschicht (24), die durch die temporäre Maske (34) definiert wird, um so die Aktivelementfläche (15) freizulegen.

5. Verfahren zum Herstellen eines MOSFET nach Anspruch 1, worin der Schritt des Bereitstellens der Maske (36) die folgenden Schritte aufweist:

a) Bereitstellen einer Metallschicht (36), welche die Oberfläche des Substrates überdeckt; und

b) Entfernen der temporären Maske (34), um so den überdeckenden Bereich der Metallschicht (36) abzuheben.

6. Verfahren zum Herstellen eines MOSFET nach Anspruch 1, worin der aktive Elementbereich (16) unter der aktiven Elementfläche (15) bereitgestellt wird, nachfolgend auf den Schritt des Freilegens der aktiven Elementfläche (15) und vor dem Bereitstellen der Maske (36), und worin eine Dotierung in das Substrat (12) implantiert wird und die Dicke des implantierten aktiven Elementbereichs (16) im Bereich von näherungsweise 0,1 µm bis näherungsweise 0,3 µm ist.

7. Verfahren nach Anspruch 6, worin die Dotierung bei einem Energiepegel im Bereich von nahezu 20 keV bis nahezu 30 keV implantiert wird bei einer Dosierung im Bereich von näherungsweise $7 \times 10^{11}$ Ionen/cm$^2$ bis näherungsweise $1.5 \times 10^{12}$ Ionen cm$^2$.

8. Verfahren zum Herstellen eines MOSFET nach Anspruch 1, worin das Substrat (12) Silicium aufweist und die Feldoxidschicht (24) Siliciumdioxid aufweist.

**Revendications**

1. Un procédé de fabrication d'un dispositif MOSFET comprenant:

un substrat (12);

une région de dispositif actif (16) sur une surface du substrat (12), cette région de dispositif actif (16) comprenant un premier dopant;

une zone d'arrêt de canal (26, 27) à la surface du substrat, en position adjacente à la région de dispositif actif, cette zone d'arrêt de canal (26, 27) comprenant un second dopant; et

une couche d'oxyde de champ (24) recouvrant la zone d'arrêt de canal (26, 27) et adjacente à cette dernière, un bord de la couche d'oxyde (24) étant aligné avec la zone d'arrêt de canal au point auquel la zone d'arrêt de canal (26, 27) est adjacente à la région de dispositif actif (16), et dans lequel l'épaisseur de la couche d'oxyde de champ (24) et la concentration du second dopant dans la zone d'arrêt de canal (26, 27) empêchent toute circulation d'un courant de fuite de niveau notable sous l'oxyde de champ (24) pendant le fonctionnement du dispositif, caractérisé par les opérations suivantes:

a) on établit une couche d'oxyde de champ (24) sur une partie de la surface du substrat (12) qui est adjacente à la zone de surface de dispositif actif (15) de la région de dispositif actif (16), un bord de la couche d'oxyde de champ (24) étant aligné avec une limite de la zone de surface de dispositif actif (15);

b) on implante un dopant (35) dans la zone de surface de dispositif actif (15) pour former la région de dispositif actif (16);

c) on forme un masque (36) recouvrant la région de dispositif actif (16);

d) on implante des ions dans le substrat avec un niveau d'énergie insuffisant pour que ces ions traversent le masque (36), mais avec une énergie suffisante pour qu'ils traversent la couche d'oxyde de champ (24), pour former une région d'arrêt de canal (40) auto-alignée avec la couche d'oxyde de champ (24) et alignée de façon correspondante avec la zone de surface de dispositif actif (15); et

e) on enlève la masque (36) et on achève la réalisation de la structure MOS.

2. Un procédé de fabrication d'un MOSFET selon la revendication 1, dans lequel on implante les ions à un niveau d'énergie dans la plage d'environ 120 keV à environ 200 keV, et avec une dose dans la gamme d'environ $5 \times 10^{12}$ ions/cm$^2$ à environ $1 \times 10^{13}$ ions/cm$^2$.

3. Un procédé de fabrication d'un MOSFET selon la revendication 1, dans lequel l'épaisseur de la couche d'oxyde de champ est dans la plage d'environ $4 \times 10^{-7}$m (4000 Å) à environ $6 \times 10^{-7}$m (6000 Å).

4. Un procédé de fabrication d'un MOSFET selon la revendication 1, dans lequel l'opération de formation de la couche d'oxyde de champ (24) comprend les opérations suivantes:

a) on forme une couche d'oxyde (24) sur la surface du substrat (12);

b) on forme sur la couche d'oxyde (24) un masque temporaire (34) définissant la limite de la zone de surface de dispositif actif (15); et

c) on enlève la partie de la couche d'oxyde (24) qui est définie par le masque temporaire (34), de façon à mettre à nu la zone de surface de dispositif actif (15).

5. Un procédé de fabrication d'un MOSFET selon la revendication 1, dans lequel l'opération de formation du masque (36) comprend les opérations suivantes:

a) on forme une couche de métal (36) qui recouvre la surface du substrat; et

b) on enlève le masque temporaire (34) de façon à décoller la partie de la couche de métal (36) qui se trouve au-dessus.

6. Un procédé de fabrication d'un MOSFET selon la revendication 1, dans lequel la région de dispositif actif (16) est établie sous la zone de surface de dispositif actif (15), après l'opération de mise à nu de la zone de surface de dispositif actif (15) et avant la formation du masque (36), et dans lequel un dopant est implanté dans le substrat (12), et l'épaisseur de la région de dispositif actif implantée (16) est dans la plage d'environ 0,1 μm à environ 0,3 μm.

7. Le procédé de la revendication 6, dans lequel le dopant est implanté avec un niveau d'énergie dans la plage d'environ 20 keV à environ 30 keV, avec une dose dans la plage d'environ $7 \times 10^{11}$ ions/cm$^2$ à environ $1,5 \times 10^{12}$ ions/cm$^2$.

8. Un procédé de fabrication d'un MOSFET selon la revendication 1, dans lequel le substrat (12) est en silicium et la couche d'oxyde de champ (24) est en dioxyde de silicium.

Fig. 1.

Fig. 2.

Fig. 3.

Fig. 4.

Fig. 5.

Fig. 6.

Fig. 7.